# EUROPEAN PATENT APPLICATION

(11) **EP 0 558 231 A2**
(43) Date of publication of application: **01.09.1993**
(21) Application number: 93301137.1
(22) Date of filing: 17.02.1993
(51) Int. Cl.: G01R 31/318, G11C 29/00

(54) **Device for testing a plurality of functional blocks in a semiconductor integrated circuit**

(30) Priority: 26.02.1992 JP 39817/92
(71) Applicant: NEC CORPORATION, Tokyo (JP)
(72) Inventor: Ohkawa, Shin-ichi, c/o NEC Corporation, Tokyo (JP)
(74) Representative: Moir, Michael Christopher

(57) **Abstract**

A device for testing a plurality of functional blocks such as RAM macros (13-1 through 13-m) in a semiconductor integrated circuit inputs plural kinds of testing signals necessary for testing the functional blocks from the exterior, and stores the testing signals to one register (11) or one latch to supply the testing signals in common to each of the functional blocks via a testing signal bus (AT,DIT,WET,BST). Thus, the plural functional blocks concurrently operate, and output their response signals. A multiplexor (15) selects one of those response signals and outputs it as the test output signal of the corresponding functional block.

## Description

### FIELD OF THE INVENTION

The present invention relates to a semiconductor integrated circuit and, in particular, to an improvement of a device for testing a plurality of functional blocks, for example, RAM macros (Random Access Memory Functional Block Macros) which are incorporated on a semiconductor chip.

### BACKGROUND OF THE INVENTION

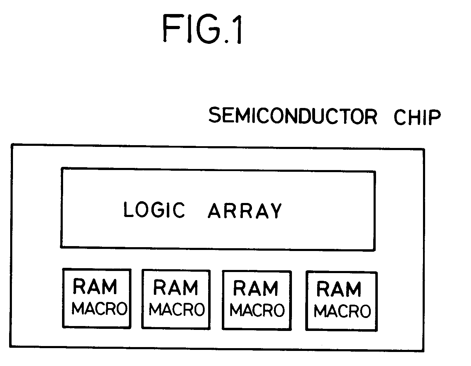

Generally, in the semiconductor chip of an integrated circuit incorporating a plurality of functional blocks such as RAM macros as shown in Fig. 1, circuits for testing those functional blocks are also incorporated therein.

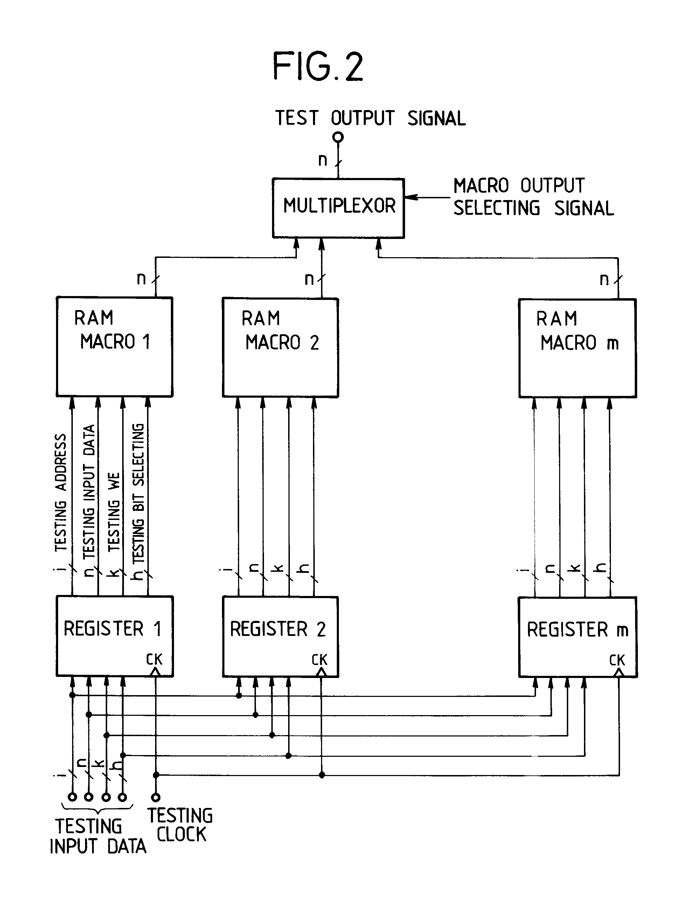

The input/output (I/O) portion of a conventional testing circuit is shown in Fig. 2. If m RAM macros 1 through m are incorporated in a semiconductor chip, in the conventional testing I/O circuit, m registers or latches need to be provided corresponding to the respective RAM macros to supply them with a testing input signal. The testing input signal is comprised of an i-bit testing address signal, an n-bit testing input data signal, a k-bit testing write enable signal, and an h-bit testing bit-selecting signal. The testing input signal as well as a testing clock signal are supplied from the external to each register through the circuit lines as shown in Fig. 2. In response to the clock signal, each register supplies the testing input signal to the corresponding RAM macro via dedicated lines. Among the n-bit macro output signals from the RAM macros, one is selected by a multiplexor as a testing output signal. The pattern of this testing output signal and the pattern of an expected output signal for the testing input signal are compared with each other to determine whether the incorporated RAM macro is good or not.

However, the conventional testing I/O circuit necessitates the same number of registers as that of the RAM macros, and the dedicated lines must be individually provided from each register to the corresponding RAM macro. Therefore, as the number of the RAM macros within a single chip is increased, the area occupied by the testing registers and the signal lines is increased forming a cause of the reduction of the scale of integration.

Accordingly, an object of the present invention is to provide a device having a testing I/O circuit which contributes to the improvement of the integrating scale by reducing the numbers of the registers and the signal lines necessary for carrying out the test.

### SUMMARY OF THE INVENTION

A device for testing a plurality of functional blocks in a semiconductor integrated circuit is comprised of a storage for storing a testing signal necessary for testing the functional blocks, signal transmitting lines for supplying the stored testing signal in common to each of the plurality of functional blocks, and a multiplexor for selecting one of the respective response signals output by the functional blocks supplied with the testing signal.

The storage supplies the testing signal in common to the plurality of functional blocks via the signal transmitting lines. Thus the plurality of functional blocks concurrently operates and the respective response signals are output from the functional blocks. The multiplexor selects one of these response signals as the testing output signal of the corresponding functional block. The operation of the multiplexor allows the testing output signals over all the functional blocks to be sequentially output. Since the testing signal can be supplied in common to the functional blocks by the foregoing signal transmitting lines, independently of the number of the functional blocks, the testing circuit can be arranged with only one storage (register or latch), and the area occupied by the circuits associated with the storage can be made smaller.

In a preferred embodiment, the storage comprises a register or a latch, and the functional block a RAM macro. Further, the testing signal includes, for example, four kinds of signals: an address signal, an input data signal, a write enable signal, and a bit-selecting signal, and the signal transmitting lines comprises, for example, an address signal bus, an input data signal bus, a write enable signal bus, and a bit-selecting signal bus.

In the signal transmitting lines, if the respective signal buses other than the address signal bus are constituted by an one-bit bus, then the occupied area can be made smaller. Further, if the respective signal buses other than the address signal bus are arranged with a two-bit bus, then the occupied area can be relatively reduced while the short-circuiting within the RAM macro can be detected as described hereinafter in more detail.

### BRIEF DESCRIPTION OF THE DRAWINGS

Fig. 1 is a view of the schematic layout of a semiconductor chip;
Fig. 2 is a circuit diagram of an I/O portion of a conventional testing circuit;
Fig. 3 is a circuit diagram of a first embodiment of an input/output portion of a testing circuit according to the present invention;
Fig. 4 is a timing chart for explaining the operation of the first embodiment according to the present invention;
Fig. 5 is a partial circuit diagram of a second embodiment according to the present invention; and
Fig. 6 is a partial circuit diagram of a third embodiment according to the present invention.

### DETAILED DESCRIPTION OF THE PRESENT INVENTION

Several preferred embodiments according to the present invention are hereinafter described in detail with reference to the accompanying drawings.

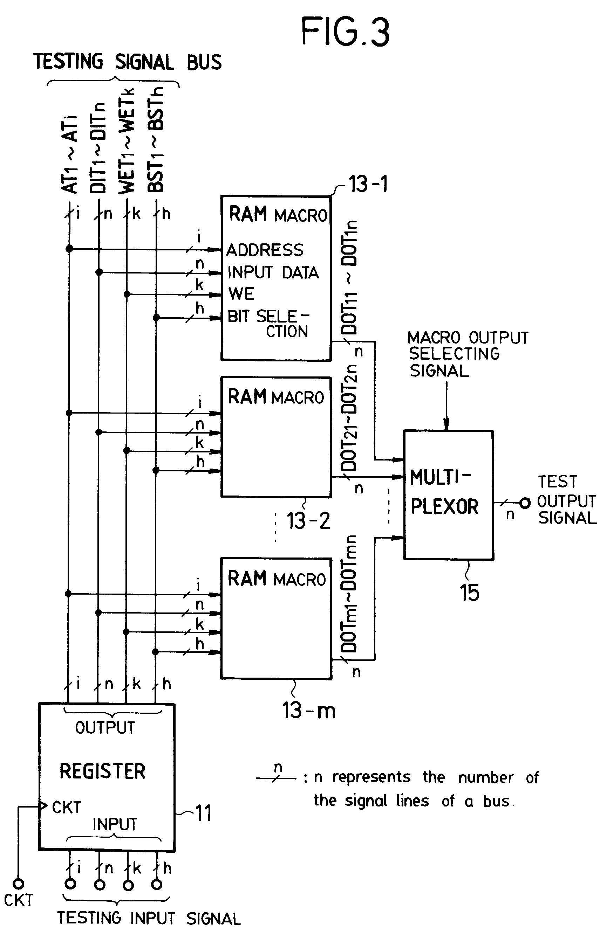

Referring to Fig. 3, let us assume that m (m: integer no less than 2) RAM macros 13-1 through 13-m are incorporated. An input/output circuit for testing these RAM macros is provided with a register 11 for storing a testing input signal. The testing input signal is comprised of an i-bit address signal, an n-bit input data signal, a k-bit write enable signal, and a h-bit bit-selecting signal. The testing input signal and a clock signal CKT are supplied to the input terminals and the clock terminal of this register 11, respectively. Incidentally, i, n, k, and h each denotes an integer.

The output terminals of the register 11 are connected to the testing signal bus which comprises four kinds of buses: an i-bit testing address bus AT comprising the signal lines AT1-ATi, an n-bit testing input data bus DIT comprising the signal lines DIT1-DITn, a k-bit testing write enable signal bus WET comprising the signal lines WET1-WETk, and a h-bit testing bit-selecting signal bus BST comprising the signal lines BST1-BSTh.

The testing signal bus is connected to the testing input terminal of each RAM macro. The testing input terminal of each RAM macro comprises an address terminal corresponding to the i-bit address bus, an input data terminal corresponding to the n-bit input data bus, a write enable terminal corresponding to the k-bit write enable signal bus, and a bit-selecting terminal corresponding to the n-bit bit-selecting bus. The n-bit output terminal of each RAM macro is connected to the corresponding n-bit input terminal of the multiplexor 15 via the corresponding n-bit macro output line. The multiplexor 15 selectively connects one of the n-bit input terminals thereof to the single n-bit output terminal according to the macro output selecting signal.

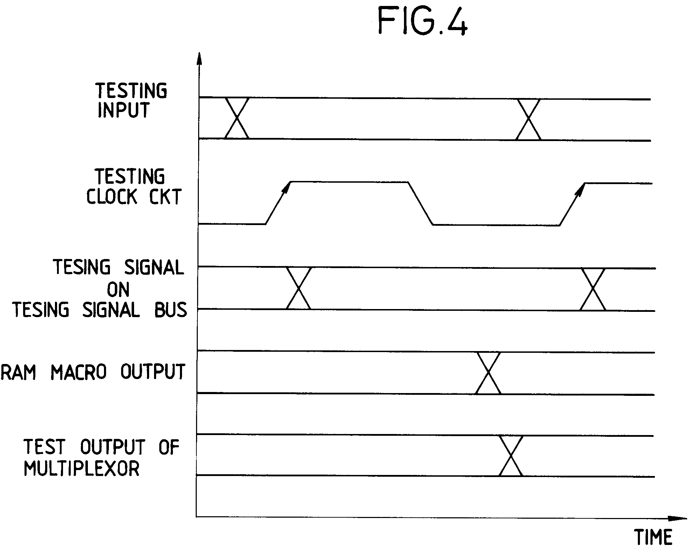

The operation of the testing circuit mentioned above is described with reference to the timing chart of Fig. 4. The given testing input signal is latched to the register 11 in synchronization with the rise of the clock signal CKT. The latched testing input signal is output to the testing signal bus and is supplied in common to the RAM macros 13-1 through 13-m. In response to the testing input signal, the RAM macros 13-1 through 13-m concurrently operate, and, upon completion of the predetermined operation, they send out their macro output signals to the multiplexor 15 via the macro output lines (DOT11-DOT1n) through (DOTml-DOTmn), respectively. The multiplexor 15 selects one of the macro output signals from the RAM macros 13-1 through 13-m according to the macro output selecting signal as the n-bit testing output signal.

The test of the plurality of RAM macros is carried out by properly altering the testing input signal entered to the register 11 and the macro output selecting signal for controlling the connecting operation of the multiplexor 15. Since the testing input signal is directly supplied in common to the m RAM macros 13-1 through 13-m by the testing signal bus, the test circuit necessitates only one register for retaining the test input signal independently of the number of the RAM macros. Therefore, the area occupied by the testing circuit in a chip can be reduced.

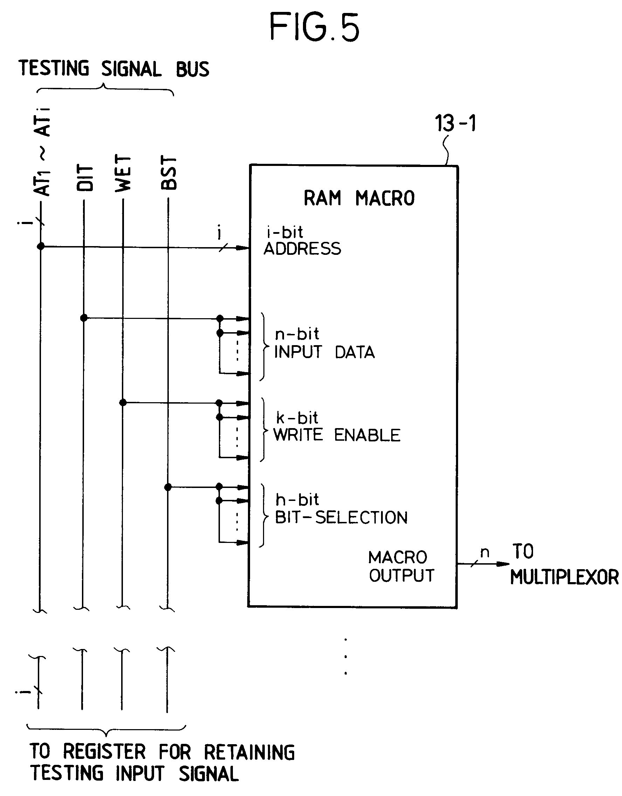

Referring to Fig. 5, in the testing signal bus, the input data bus DIT, the write enable signal bus WET, and the bit-selecting signal bus BST are each arranged with a one-bit bus, and the address bus is arranged with an i-bit bus as in the circuit of Fig. 3. The one-bit input data bus DIT is connected to the bit connection points (pins) of the n-bit input data terminal of each RAM macro, the one-bit write enable signal bus WET to the bit pins of the k-bit write enable signal terminal, and the one-bit bit-selecting signal bus BST to the bit pins of the h-bit bit-selecting signal terminal. The i-bit address bus (AT1-ATi) is connected to the i-bit address terminal of each RAM macro. Thus, by employing the one-bit bus arrangement, the area occupied by the testing signal bus can further be reduced. The reason such a simplification of the circuit can be made is that the test of a RAM macro can acceptably be carried out by giving the corresponding same signal to the bit pins of each testing terminal of the input data terminal, the write enable signal terminal, and the bit-selecting signal terminal.

It should be noted that in Fig. 5 for simplification only the part of the circuit associated with the RAM macro 13-1 of Fig. 3 is illustrated in detail. Further, in Fig. 5, the register for retaining the testing input signal is not shown because its object and fundamental function are the same as the register 11 of Fig. 1.

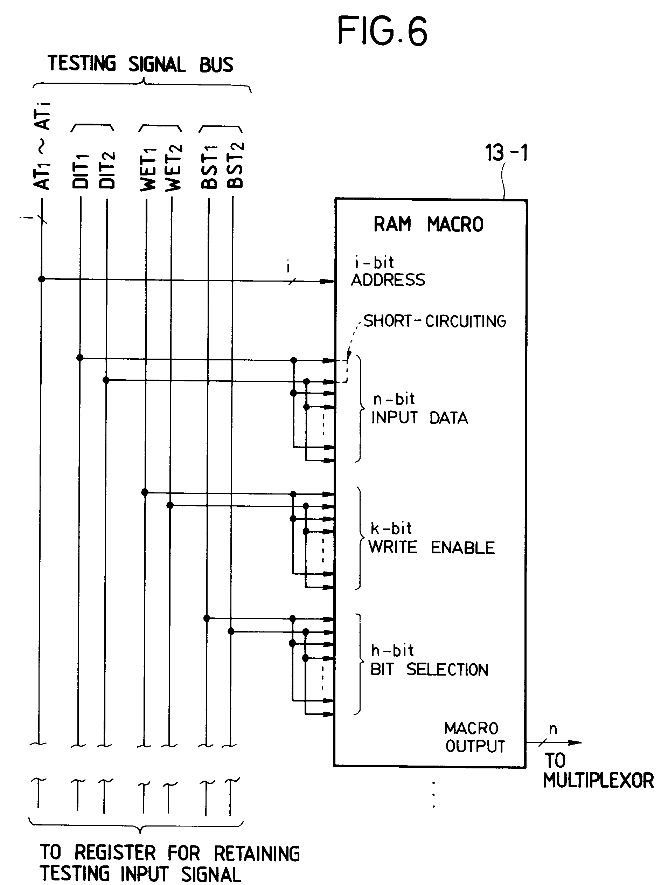

Referring to Fig. 6, in the testing signal bus, the input data bus DIT, the write enable signal bus WET, and the bit-selecting signal bus BST are each arranged with a two-bit bus, and the address bus is arranged with the i-bit bus as in the circuit of Fig. 3. In the input data bus DIT, the one-bit input data bus DIT1 is connected in common to the even-numbered (or odd-numbered) bit pins of the input data terminal of each RAM macro, and the other one-bit input data bus DIT2 is connected in common to the remaining bit pins. Similarly, as shown in Fig. 6, the write enable signal bus (WET1 and WET2) and the bit-selecting signal bus (BST1 and BST2) are also connected to the write enable signal terminal and the bit-selecting signal terminal of each RAM macro, respectively.

In such a two-bit bus arrangement, the register for retaining the testing input signal outputs the testing input data signal to two one-bit buses DIT1 and DIT2 of the input data bus alternately. The same is true of the write enable signal bus (WET1 and WET2) and the bit-selecting signal bus (BST1 and BST2) each comprising two one-bit buses. Employing the two-bit bus arrangement and its operation, a short circuit can be detected within each RAM macro. As shown in Fig. 6, the short-circuiting is indicated by a broken line by way of example between the adjacent bit pins of the testing input data terminal. Further, since the test signal buses DIT, WET and BST are each having a two-bit bus arrangement, the area occupied by the testing signal bus can be made relatively small.

Incidentally, in Fig. 6, in order to simplify the description, only the part of the circuit associated with the RAM macro 13-1 of Fig. 3 is shown in more detail. Further, in Fig. 6, the register for retaining the testing input signal is not shown because its object and fundamental function are the same as the register 11 of Fig. 1.

The present invention is not necessarily restricted to the foregoing embodiments, but various changes and modification can be made. Although, in the detailed description, there were shown several examples of the semiconductor integrated circuit having a plurality of RAM macros, the present invention can be also applied to other testing circuits for a plurality of functional circuits having the same or a similar structure.

## Claims

1. Device for testing a plurality of functional blocks (13-1 through 13-m) in an integrated circuit, characterized in that said device comprises:
storage means (11) for storing plural kinds of testing signals necessary for testing said functional blocks;
signal transmitting means (AT,DIT,WET,BST) for supplying said stored testing signals in common to each of said functional blocks; and
selecting means (15) for selecting one of the response signals output by said respective functional blocks in response to said testing input signal.

2. Device as set forth in Claim 1 wherein said storage means (11) comprises one register.

3. Device as set forth in Claim 1 wherein said functional block comprises a RAM macro (Random Access Memory functional block Macro).

4. Device as set forth in Claim 1 wherein said selecting means (15) comprises a multiplexor.

5. Device as set forth in Claim 1 wherein said testing signal comprises four kinds of testing signals: an address signal, an input data signal, a write enable signal, and a bit-selecting signal, and said signal transmitting means comprises an address signal bus (AT) , an input data signal bus (DIT), a write enable signal bus (WET), and a bit-selecting signal bus (BST).

6. Device as set forth in Claim 1 wherein said functional block comprises a RAM macro, and said testing signal comprises four kinds of testing signals: an address signal, an input data signal, a write enable signal, and a bit-selecting signal, and said signal transmitting means comprises an address signal bus (AT), an input data signal bus (DIT), a write enable signal bus (WET), and a bit-selecting signal bus (BST).

7. Device as set forth in Claim 6 wherein said RAM macro has a testing input terminal comprising an i-bit address input terminal, an n-bit input data terminal, a k-bit write enable signal input terminal, and an h-bit bit-selecting signal input terminal, where i, n, k, and h each denotes an integer.

8. Device as set forth in Claim 7 wherein said signal transmitting means comprises an i-bit address signal bus (AT), an n-bit input data signal bus (DIT), a k-bit write enable signal bus (WET), and an h-bit bit-selecting signal bus (BST).

9. Device as set forth in Claim 7 wherein said signal transmitting means comprises an i-bit address signal bus (AT), a one-bit input data signal bus (DIT), a one-bit write enable signal bus (WET), and a one-bit bit-selecting signal bus (BST).

10. Device as set forth in Claim 9 wherein said i-bit address signal bus is connected to the i-bit address input terminal of each RAM macro, and each of said one-bit buses is connected in common to the bit pieces of the corresponding one of said n-bit input data terminal, said k-bit write enable signal input terminal, and said h-bit bit-selecting signal input terminal of said relevant RAM macro.

11. Device as set forth in Claim 7 wherein said signal transmitting means comprises an i-bit address signal bus (AT), a two-bit input data signal bus (DIT), a two-bit write enable bus (WET), and a two-bit bit-selecting signal bus (BST).

12. Device as set forth in Claim 11 wherein said i-bit address signal bus (AT) is connected to the i-bit address input terminal of each RAM macro; two one-bit buses of said two-bit input data signal bus (DIT) are alternately connected to the bit pieces of the input data terminal of said relevant RAM macro; two one-bit buses of said two-bit write enable signal bus (WET) are alternately connected to the bit pieces of the write enable signal terminal; and two one-bit buses of said two-bit bit-selecting signal bus (BST) are alternately connected to the bit pieces of the bit-selecting signal terminal.
